# EUROPEAN PATENT APPLICATION

(11) **EP 4 704 145 A1**
(43) Date of publication of application: **04.03.2026**
(21) Application number: 24796776.3
(22) Date of filing: 09.04.2024
(51) Int. Cl.: H01L 21/677, B25J 15/06, H01L 21/683

(54) **WORKPIECE HOLDING DEVICE**

(30) Priority: 27.04.2023 JP 2023073305
(71) Applicant: Creative Technology Corporation, Kawasaki-shi, Kanagawa 213-0034 (JP)
(72) Inventor: ONODERA Hiromitsu, Kawasaki-shi, Kanagawa 213-0034 (JP)
(74) Representative: Kraus & Lederer PartGmbB
(86) International application number: PCT/JP2024/014363
(87) International publication number: WO 2024/225020

(57) **Abstract**

Provided is a workpiece holding device capable of surely holding even a heavy workpiece and enabling the held workpiece to be removed without applying a load to it. In the workpiece holding device, a self-adhesive adhesive holding material 2 is attached to one surface of an elastically deformable belt-like sheet 1, the belt-like sheet 1 is locked to a pedestal block 5 having a locking part 4, with the adhesive holding material 2 facing outward, and an integrating means is included which brings a base surface 5a of the pedestal block 5 and the other surface 1a of the belt-like sheet 1 into close contact with each other to integrate them, and in holding the workpiece, the pedestal block 5 and the belt-like sheet 1 are integrated by the integrating means to form a workpiece holding surface, thereby adhesively holding the workpiece, and in removing the workpiece, integration of the pedestal block 5 and the belt-like sheet 1 is disengaged to separate the base surface of the pedestal block and the other surface of the belt-like sheet, thereby being able to peel off the workpiece from the workpiece holding surface.

## Description

### Technical Field

This invention relates to a workpiece holding device for holding a workpiece using a self-adhesive adhesive holding material, and specifically to a workpiece holding device capable of holding even a heavy workpiece and removing the held workpiece without applying any load to it.

### Background Art

On occasions where various workpieces including semiconductor wafers and glass substrates are transported or picked up, in general, a vacuum chuck that attracts a workpiece with a vacuum attraction force or an electrostatic chuck that attracts a workpiece with an electrostatic attraction force are used.

However, the vacuum chuck cannot be used in a decompression device. Further, in the case of a thin, breakable workpiece, vacuum traces could remain after attraction or occasionally, the workpiece could be broken. Meanwhile, the electrostatic chuck occasionally fails to attract a workpiece of certain materials or requires a high voltage to increase the attraction force. Therefore, as alternatives to these, some methods capable of holding a workpiece using a simple system for any type of workpiece and without being subject to facility restrictions have been considered.

For example, a device has been proposed in which an unused adhesive tape having a high adhesive force is constantly supplied while an adhesive tape that is wound around a supply roll is reeled on a take-up roll, and with the use of the two adhesive tapes, a workpiece is caused to adhesively adhere to and to thereby be held on their adhesive surfaces, and then, a pressing pin is pressed from above into a gap between the two adhesive tapes to push out the held workpiece downward so as to peel off the workpiece (see Patent Literature 1).

Further, an electronic component transporting head has been proposed in which an adhesive surface of an adhesive tape is pressed by a pressing block from above against an electronic component (workpiece) to cause it to adhesively adhere to the adhesive surface, and then, the pressing block is raised while holding the electronic component and at this time, the periphery of the electronic component is brought into contact with a guide member to prevent the electronic component itself from rising, thereby peeling off the electronic component (see Patent Literature 2).

In addition, a picking device has been proposed in which while supplying an adhesive tape between a tape holder on a supply side and a tape holder on a recovery side, a workpiece is caused to adhesively adhere, and after adhesion of the workpiece, an excitation rotor positioned above the region of adhesion and having an eccentric cam is raised and lowered so that the workpiece is peeled off by shaking (see Patent Literature 3).

Meanwhile, a device has been proposed in which a workpiece is held by a holding means including an adhesive coating layer coated with an adhesive, and then, when the workpiece is released, a plurality of air chambers positioned above the holding means and inflatable with air are expanded to curve the holding means so that the workpiece is separated from the adhesive coating layer (see Patent Literature 4).

Furthermore, a workpiece transporting device has been proposed in which a self-adhesive adhesive layer is stacked on a surface of an endless belt, which is formed as a belt conveyor using a drive roller and a driven roller so that a workpiece adhesively held on the adhesive layer is transported (see Patent Literature 5).

### Citation List

### Patent Literature

Patent Literature 1: JP H2-190287 A
Patent Literature 2: JP 2001-85896 A
Patent Literature 3: JP 2018-176289 A
Patent Literature 4: Japanese Translation of PCT International Application Publication No. 2014-509953
Patent Literature 5: JP 2014-162571 A

### Summary of Invention

### Technical Problem

When an adhesive tape or the like is used to hold a workpiece as described above, a sufficient holding force on the workpiece needs to be exhibited. At the same time, how to separate the held workpiece is important.

For example, when an adhesive tape in which an adhesive is applied to a base material of the tape such as cellophane is used, the holding force (adhesive force) on the workpiece can be enhanced by increasing an adhesive surface (bonding surface) relative to the workpiece.

However, for peeling off an adhesive tape adhering to a workpiece, various ingenious approaches are required as described in the aforementioned Patent Literatures 1 to 3. Moreover, a large load is exerted on the workpiece in doing so.

On the other hand, unlike an adhesive tape to which an adhesive is applied, when a workpiece is adhesively held on a self-adhesive adhesive holding material as described in Patent Literature 5 or a partially cross-linked silicone resin as listed in Patent Literature 4 (paragraph 0033 of the description) is used, the force required to peel off the workpiece is relatively small.

However, as the adhesive force is reduced, the workpiece that can be held is limited accordingly. In particular, depending on the weight of the workpiece, the adhesive holding surface to which the workpiece adhesively adheres could bend or twist, thereby dropping the workpiece. Therefore, there is a trade-off issue between increasing the adhesive holding force on the workpiece and enabling separation with the least load applied to the workpiece.

Thus, the inventors of the present invention have diligently considered means capable of surely holding a workpiece and enabling separation with the least load applied to the workpiece, and as a result, have found that by attaching a self-adhesive adhesive holding material to an elastically deformable belt-like sheet and using the belt-like sheet in combination with a pedestal block, all the aforementioned problems can be resolved, and completed the present invention.

Accordingly, an object of the present invention is to provide a workpiece holding device capable of surely holding even a heavy workpiece and enabling separation without applying a load to the held workpiece.

### Solution to Problem

Specifically, the present invention is a workpiece holding device for holding a workpiece using a self-adhesive adhesive holding material, the workpiece holding device including:
a belt-like sheet having one surface to which the adhesive holding material is attached, the belt-like sheet being elastically deformable;
a pedestal block having a base surface; and
an integrating means adapted to bring the base surface of the pedestal block and another surface of the belt-like sheet into close contact with each other to be integrated, in which
in holding the workpiece, the pedestal block and the belt-like sheet are integrated by the integrating means to form a workpiece holding surface, thereby adhesively holding the workpiece, and
in removing the workpiece, integration of the pedestal block and the belt-like sheet by the integrating means is disengaged to separate the base surface of the pedestal block and the other surface of the belt-like sheet, thereby peeling off the workpiece from the workpiece holding surface.

The workpiece holding device of the present invention includes: the belt-like sheet having one surface to which the adhesive holding material is attached, the belt-like sheet being elastically deformable; the pedestal block having the base surface; and the integrating means adapted to bring the base surface of the pedestal block and the other surface of the belt-like sheet into close contact with each other to be integrated.

Further, in holding the workpiece, the pedestal block and the belt-like sheet are integrated by the integrating means to form the workpiece holding surface so that the belt-like sheet is made to follow the base surface of the pedestal block. In this manner, deformation of the elastically deformable belt-like sheet is restricted and the adhesive holding material attached to the belt-like sheet can be brought into contact with the workpiece on the workpiece holding surface that is flush with the workpiece, thereby enabling the workpiece to be surely, adhesively held.

Meanwhile, in removing the workpiece, integration of the pedestal block and the belt-like sheet by the integrating means is disengaged to separate the base surface of the pedestal block and the other surface of the belt-like sheet. That is, by returning the adhesive holding material that forms the workpiece holding surface to a freely deformable state, it becomes possible to roll up the belt-like sheet from the workpiece adhesively held on the workpiece holding surface, thereby enabling the workpiece to be peeled off from the workpiece holding surface.

In this manner, by attaching the self-adhesive adhesive holding material to the elastically deformable belt-like sheet and combining this belt-like sheet with the pedestal block, in holding the workpiece, the pedestal block and the belt-like sheet are integrated to form the workpiece holding surface, so that even a heavy workpiece can be surely held. Further, in removing the workpiece, the integration of the pedestal block and the belt-like sheet by the integrating means is disengaged to separate the pedestal block and the belt-like sheet, so that easy separation without applying a load to the held workpiece becomes possible.

Here, the belt-like sheet only needs to be elastically deformable so as to be able to follow the workpiece attaching and detaching operations as described above, and the material and the like are not particular limited, but for example, those made of resin, such as a resin film, or metal may be used or those made of paper, cloth, and the like may be used.

Further, the adhesive holding material is self-adhesive. This differs from an adhesive tape (bonding tape) on the market, in which an adhesive is applied to a base material such as cellophane, and the adhesive holding material itself has adhesiveness (self-adhesiveness). Thus, when peeled off from a target object (workpiece) after being attached, the adhesive tape reduces its adhesiveness by the adhesive and can no longer be available for repeated use, while the self-adhesive adhesive holding material can be used to hold and peel off workpieces repeatedly. In that case, further repeated use becomes available by performing surface cleaning.

Preferable examples of such a self-adhesive adhesive holding material may include those made of resin, such as silicone rubber, ethylene-propylene-diene monomer (EPDM), butyl rubber, fluorine-based resin, urethane-based resin, and acrylic resin. Among other things, those capable of exhibiting the van der Waals force, which is one type of the intermolecular force, at an interface with the workpiece to be adhesively held are preferable.

In addition, it is preferable that the pedestal block have a base surface along which the belt-like sheet follows to form a workpiece holding surface and also include a locking part that can lock the belt-like sheet, with the adhesive holding material attached to the belt-like sheet facing outward. Further, the pedestal block may be made of metal, resin, or the like, and the material or the like is not particularly limited.

Further, as described above, the integrating means only needs to be capable of forming the workpiece holding surface by bringing the base surface of the pedestal block and the other surface of the belt-like sheet into close contact with each other to be integrated and releasing the state so as to separate the base surface of the pedestal block and the other surface of the belt-like sheet. The specific means is not particularly limited, but may preferably include the following means.

That is, the integrating means is formed by an electromagnet attached to the pedestal block and the belt-like sheet made of a magnetic material, so as to be able to bring an inner side surface of the belt-like sheet and the base surface of the pedestal block into close contact with each other, with an excitation current supplied to the electromagnet.

Further, the integrating means is formed by a suction pump connected to the pedestal block and a suction port that sucks the inner side surface of the belt-like sheet, so as to be able to bring the inner side surface of the belt-like sheet and the base surface of the pedestal block into close contact with each other, by sucking air with the suction pump. In addition to these, the inner side surface of the belt-like sheet and the base surface of the pedestal block may be brought into close contact with each other by, for example, providing an electrostatic chuck on the pedestal block side so as to exhibit an electrostatic attraction force.

In the workpiece holding device of the present invention, in removing the workpiece, the workpiece may be peeled off from the workpiece holding surface while restricting movement of the workpiece by a workpiece restricting means that restricts the movement of the workpiece toward the pedestal block. Specifically, in peeling off the workpiece from the workpiece holding surface, the workpiece holding surface is peeled off from the workpiece while pressing an upper surface of the workpiece by the workpiece restricting means, thereby enabling the workpiece to be more surely removed.

Furthermore, as described above, the workpiece holding device of the present invention may include a through-hole passing through from the pedestal block to the belt-like sheet, with the workpiece holding surface formed by the pedestal block and the belt-like sheet closely contacting with each other. Specifically, by providing the through-hole passing through from an upper surface (a surface opposite to the base surface) or a side surface of the pedestal block to the belt-like sheet and through observation of a gas flow within the through-hole, a state of adhesively holding the workpiece on the workpiece holding surface is detected. For example, with the workpiece being held on the workpiece holding surface, if gas escapes (leaks) through the through-hole, the workpiece failing to closely contact the workpiece holding surface is indicated.

The workpiece to be adhesively held in the workpiece holding device of the present invention is not particularly limited as long as it can be adhesively held by the self-adhesive adhesive holding material, and examples thereof may include those made of various types of materials such as metal material such as aluminum or stainless steel, and resin films, including semiconductor wafers and glass substrates. Further, materials, components (parts), or the like for use in manufacturing processes can also be adhesively held as workpieces.

### Advantageous Effects of Invention

According to the present invention, a workpiece can be held with a sufficient adhesive force, and separation without applying a load to the held workpiece is possible. Therefore, for example, it is possible to hold even a heavy workpiece without dropping it and to separate even a thin, weak workpiece without scratching or damaging the workpiece.

Moreover, the workpiece holding device of the present invention adhesively holds a workpiece using the self-adhesive adhesive holding material, and is thus versatile for any type or shape of workpiece and is not subject to any particular facility restrictions. Therefore, application in a broad range is available, for example, for use as a workpiece transporting device for transporting various types of workpieces or use as part of a robot hand that picks up workpieces.

### Brief Description of Drawings

[Figure 1] Figure 1 is an explanatory perspective view of a workpiece holding device according to the present invention from above.
[Figure 2] Figure 2 is an explanatory side view of the workpiece holding device according to the present invention.
[Figure 3] Figure 3 is an explanatory plan view of the workpiece holding device according to the present invention from below.
[Figure 4] Figure 4(a) is an explanatory schematic view showing a case in which a workpiece is adhesively held using the workpiece holding device; and Figure 4(b) is an explanatory schematic view showing a case in which the workpiece is removed in the same manner.
[Figure 5] Figure 5 is an explanatory schematic view showing observation of a state of adhesively holding a workpiece using a through-hole passing through from a pedestal block to an adhesive holding material: (a) shows a case of the workpiece properly held; and (b) shows a case of the workpiece not properly held.
[Figure 6] Figure 6 is an explanatory schematic view showing a state of the through-hole passing through from the pedestal block to the adhesive holding material: (a) is a side view; and (b) is a plan view from below.
[Figure 7] Figure 7 is an explanatory schematic view showing a modification of the through-hole passing through from the pedestal block to the adhesive holding material: (a) is a side view; and (b) is a plan view from below.
[Figure 8] Figure 8 is an explanatory schematic view showing another modification of the through-hole passing through from the pedestal block to the adhesive holding material: (a) is a side view; and (b) is a plan view from below.

### Description of Embodiment

Hereinafter, the present invention will be specifically described with reference to the drawings. Note that the present invention is not limited to those contents.

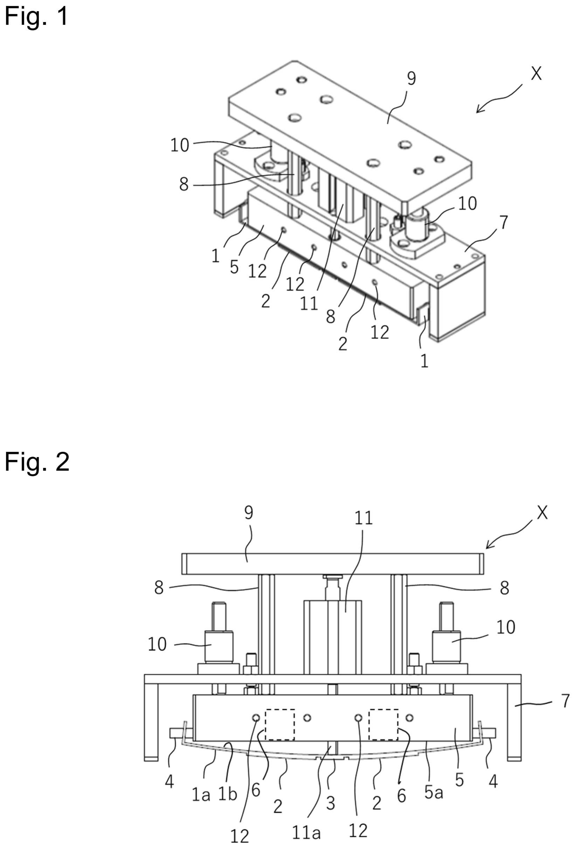

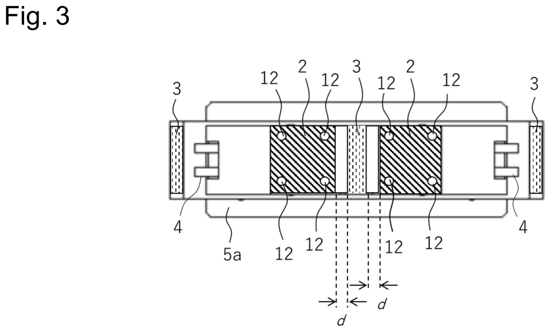

Figures 1 to 3 show an example of a workpiece holding device according to the present invention. Specifically, Figure 1 is an explanatory perspective view of a workpiece holding device X from above. Figure 2 is an explanatory side view, and Figure 3 is an explanatory plan view from below. In this workpiece holding device X, a self-adhesive adhesive holding material 2 is attached to one surface 1a of a belt-like sheet 1 that is elastically deformable, and the belt-like sheet 1 is locked to a base surface 5a of a pedestal block 5 having locking parts 4 at opposite ends, with the adhesive holding material 2 facing outward.

Further, two electromagnets 6 are embedded inside the pedestal block 5 and the previously described belt-like sheet 1 is formed of a magnetic material, so that an integrating means is formed which integrates the base surface 5a of the pedestal block 5 with an inner side surface 1b (a surface not having the adhesive holding material 2) of the belt-like sheet 1. Specifically, by supplying an excitation current to a coil of the electromagnets 6 from a power source that is not shown, the inner side surface 1b of the belt-like sheet 1 made of a magnetic material, such as iron, stainless steel, or a resin sheet containing iron powder and the base surface 5a of the pedestal block 5 are brought into close contact with each other, thereby enabling a workpiece holding surface S for holding the workpiece to be formed.

In this workpiece holding device X, the pedestal block 5 is housed on an inner side of a workpiece pressing portion 7 having a U-shaped cross section, and four supports 8 stand on the pedestal block 5 so as to extend through the U-shaped workpiece pressing portion 7, and an upper plate 9 is attached to their tips. In addition, vertical guides 10 that guide the up-down movement of the pedestal block 5 are attached to the opposite ends of the U-shaped workpiece pressing portion 7, and an air cylinder 11 is attached to the center of the U-shaped workpiece pressing portion 7. A rod 11a of the air cylinder 11 is fixed to the U-shaped workpiece pressing portion 7 and extends through the pedestal block 5 so that the tip of the rod 11a is also fixed to the belt-like sheet 1. Further, in removing (de-chucking) the workpiece described later, the rod 11a as well as the U-shaped workpiece pressing portion 7 functions as a workpiece restricting means that restricts movement of a workpiece w toward the pedestal block 5.

Here, the adhesive holding material 2 is made of silicone rubber, ethylene-propylene-diene monomer (EPDM), butyl rubber, fluorine-based resin, urethane-based resin, acrylic resin, and the like, and has self-adhesiveness that exhibits the van der Waals force, which is one type of the intermolecular force. In the workpiece holding device X in this example, as shown in Figure 3, the adhesive holding materials 2 are provided at two locations on an outer side surface 1a of the belt-like sheet 1. Further, a non-adhesive holding material 3 made of rubber having no adhesiveness is provided between the two adhesive holding materials 2 so as to be aligned in thickness (height) with these adhesive holding materials 2. Furthermore, in this workpiece holding device X, the non-adhesive holding material 3 is also provided at each of the opposite ends of the belt-like sheet 1. These adhesive holding materials 2 and non-adhesive holding materials 3 are aligned at the same height (flush with each other) when the pedestal block 5 and the belt-like sheet 1 are integrated by the integrating means composed of the electromagnet 6 and the belt-like sheet 1 to form the workpiece holding surface S.

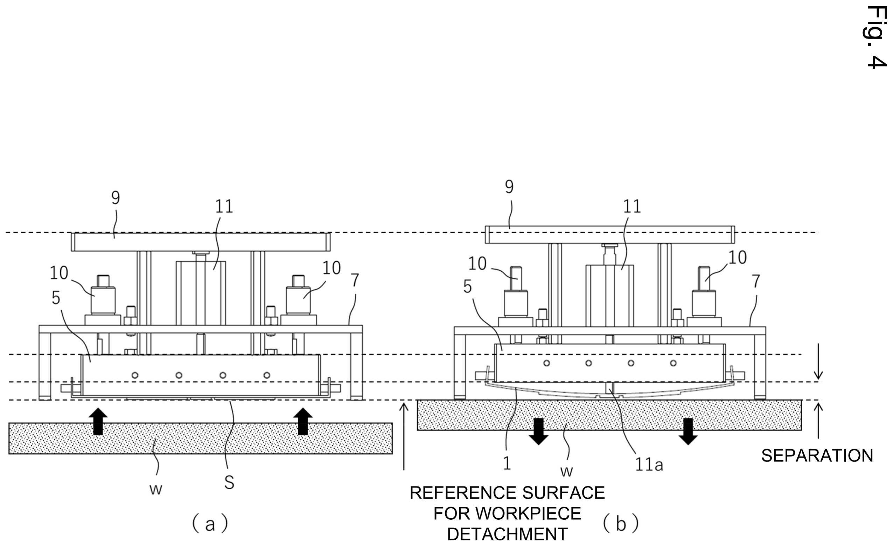

In holding a workpiece using this workpiece holding device X, as shown in Figure 4(a), first, an excitation current is made to flow through the coil of the electromagnet 6 constituting the integrating means, thereby bringing the inner side surface 1b of the belt-like sheet 1 made of a magnetic material and the base surface 5a of the pedestal block 5 into close contact with each other. Then, with this state, the workpiece w is brought relatively closer to the workpiece holding surface S, and the workpiece w is adhesively held by the adhesive holding material 2 on the workpiece holding surface S. At this time, the pedestal block 5 may press the adhesive holding material 2 of the workpiece holding surface S against the workpiece w through the upper plate 9. Further, the workpiece w may be adhesively held by bringing the workpiece w relatively closer to the workpiece holding surface S while integrating the pedestal block 5 and the belt-like sheet 1 by the integrating means, or the belt-like sheet 1 is brought relatively closer to be in contact with the workpiece w and then, the pedestal block 5 and the belt-like sheet 1 may be integrated by the integrating means.

Meanwhile, in removing the workpiece, as shown in Figure 4(b), first, the integration of the pedestal block 5 and the belt-like sheet 1 by the integrating means is disengaged. Then, the air cylinder 11 is actuated to push up the upper plate 9, thereby separating the base surface 5a of the pedestal block 5 and the other surface 1b of the belt-like sheet 1. Specifically, with the air cylinder 11 actuated (the rod of the air cylinder 11 extended) to push up the upper plate 9 by means of the rod of the air cylinder 11, the pedestal block 5 rises and the belt-like sheet 1 rises at the locking parts of the pedestal block. At this time, the center portion of the belt-like sheet 1 is in a state of being pressed against the workpiece w by the rod 11a fixed to the U-shaped workpiece pressing portion 7, and similarly, the U-shaped workpiece pressing portion 7 presses a top surface of the workpiece w with its tip, thereby restricting the movement of the workpiece w toward the pedestal block 5, and as a result, the opposite ends of the belt-like sheet 1 are rolled up and the workpiece w is peeled off from the workpiece holding surface S. Note that in this example of the workpiece holding device X, the rod 11a is located at substantially the center of the belt-like sheet 1, but the workpiece may be peeled off from the workpiece holding surface S by, for example, providing the air cylinder 11 on an end side of the belt-like sheet and while pressing one side of the belt-like sheet 1, rolling up the remaining end.

Further, in this example, as the integrating means for integrating the pedestal block 5 and the belt-like sheet 1 of the workpiece holding device X, the belt-like sheet 1 is formed of a magnetic material and the electromagnet 6 is attached to the pedestal block 5 so as to be able to bring the inner side surface 1b of the belt-like sheet 1 and the base surface of the pedestal block 5 into close contact with each other, but in addition to this, the inner side surface 1b of the belt-like sheet 1 and the base surface 5a of the pedestal block 5 may be brought into close contact with each other by, for example, forming a suction hole on the base surface 5a of the pedestal block 5 to perform suction using a suction pump or the like. Further, the inner side surface 1b of the belt-like sheet 1 and the base surface of the pedestal block 5 may be enabled to be brought into close contact with each other by incorporating an attraction electrode into the pedestal block 5 to exhibit an electrostatic attraction force on the base surface 5a.

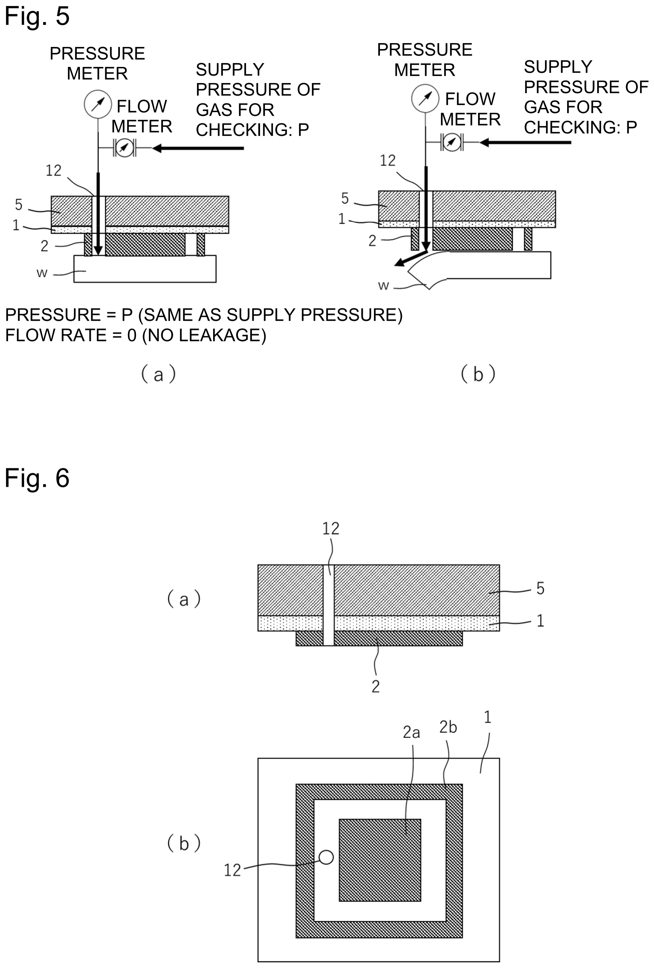

In addition, in the present invention, a through-hole 12 passing through from the pedestal block 5 to the belt-like sheet 1 may be provided, with the workpiece holding surface S formed by the pedestal block 5 and the belt-like sheet 1 closely contacting with each other. This allows detection of a state of adhesively holding the workpiece w on the workpiece holding surface S through observation of a gas flow within the through-hole 12. For example, as shown in Figure 5, with the workpiece w held on the workpiece holding surface S, gas for checking is supplied with a supply pressure P from the pedestal block 5 side to an inlet of the through-hole 12, and after checking the pressure at the initial state, the pressure is continuously observed over time. At this time, if the gas pressure is the same as the pressure at the initial state (if there is no leakage), it is determined that the workpiece w is properly, adhesively held on the workpiece holding surface S (Figure 5(a)). On the other hand, if the gas pressure changes from the pressure at the initial state (if the pressure decreases by the amount of leakage), it is determined that the workpiece w is not properly, adhesively held on the workpiece holding surface S (Figure 5(b)).

Although Figure 5 above shows a case example in which gas for checking is supplied, the pressure may be checked by discharging gas from the through-hole 12 using a pump. If there is no leakage, the ultimate vacuum pressure is constant and it is determined that the workpiece w is properly, adhesively held on the workpiece holding surface S (Figure 5(a)). On the other hand, if the ultimate vacuum pressure is low (if the pressure increases by the amount of leakage), it is determined that the workpiece w is not properly, adhesively held on the workpiece holding surface S (Figure 5(b)). In addition to the determination method using pressure, similar determination is also available by monitoring the flow rate using a flow meter.

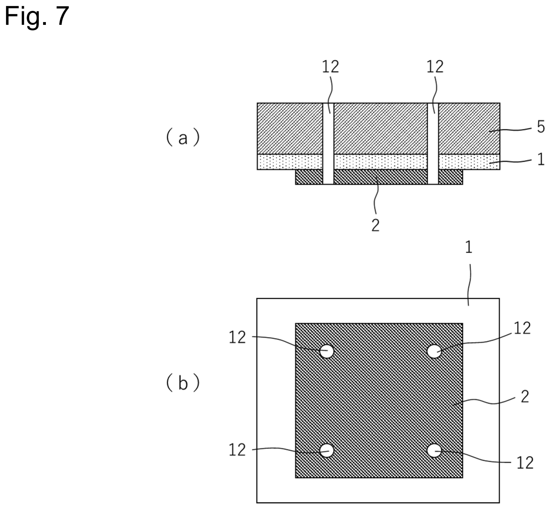

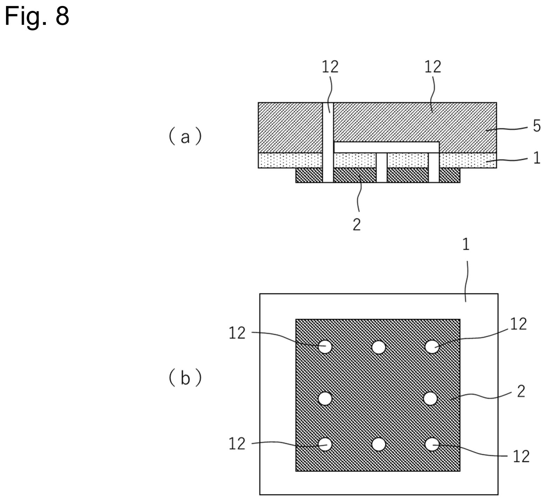

Here, in the previous example of the workpiece holding device X, the through-hole 12 passing through from a side surface of the pedestal block 5 to the adhesive holding material 2 of the belt-like sheet 1 is provided, but for example, as shown in Figure 6, the through-hole 12 may pass through in the thickness direction of the pedestal block 5, and the adhesive holding material 2 on the belt-like sheet 1 side may be composed of a first adhesive holding material 2a and a second adhesive holding material 2b surrounding this, thereby forming a closed gas flow path between these first and second adhesive holding materials 2a, 2b. Further, as shown in Figure 7, a plurality of through-holes 12 passing through up to the adhesive holding material 2 attached to the belt-like sheet 1 may be provided so as to correspond to a planar shape of the adhesive holding material 2. Furthermore, as shown in Figure 8, by coupling the through-holes 12 together inside the pedestal block 5, the number of outlets of the through-holes 12 on the belt-like sheet 1 side may not correspond to the number of inlets of the through-holes 12 on the pedestal block 5 side.

### [Example]

An experiment of adhesively holding a test workpiece was conducted using the workpiece holding device X described above.

Here, for the belt-like sheet 1, elastically deformable SUS410 (martensitic stainless steel: ferromagnetic) having 30 mm in width x 130 mm in length x 1 mm in thickness was used. Further, as the adhesive holding material 2, two sheets of self-adhesive adhesive holding materials, each having 30 mm in width x 30 mm in length x 1 mm in thickness, were used, and one sheet of non-adhesive holding material 3 having 10 mm in width x 30 mm in length x 1 mm in thickness was used, and these were arranged at d = 5 mm on one surface 1a of the belt-like sheet 1 and bonded together with an acrylic adhesive, as shown in previous Figure 3. Furthermore, two non-adhesive holding materials 3, each having 6 mm in width x 34 mm in length x 1 mm in thickness, were prepared and bonded to the opposite ends of the belt-like sheet 1 with an acrylic adhesive so that the adhesive holding materials 2 and the non-adhesive holding materials 3 were aligned at the same height. Note that the above-described adhesive holding material 2 has self-adhesiveness capable of adhesively holding the test workpiece, upon contacting the surface of the test workpiece, by the van der Waals force of the surface.

Further, as the workpiece to be adhesively held, three types of those (all made of an aluminum alloy) were prepared: test workpiece w1 having 200 mm in width x 200 mm in length x 10 mm in thickness and 1.1 kg in weight; test workpiece w2 having 250 mm in width x 250 mm in length x 10 mm in thickness and 1.7 kg in weight; and test workpiece w3 having 300 mm in width x 450 mm in length x 10 mm in thickness and 3.7 kg in weight. These were adhesively held using the workpiece holding device X, while being placed on a flat table, and whether they were dropped was checked in the following manner.

First, in adhesively holding the test workpieces using the workpiece holding device X, with the rod of the air cylinder 11 retracted, the adhesive holding material 2 of the belt-like sheet 1 was brought into contact with the surface of the test workpieces, the upper plate 9 was pressed to apply pressure using the pedestal block 5, and then, DC 24V was supplied to the two electromagnets 6 (the electromagnets were turned ON). This brings the other surface 1b of the elastically deformable belt-like sheet 1 and the base surface 5a of the pedestal block 5 into close contact with each other to be integrated (deformation of the elastically deformable belt-like sheet 1 restricted), thereby forming a workpiece holding surface P to enable the test workpieces to be adhesively held. Note that the electromagnet 6 has a diameter of 15 mm and a length of 15 mm, a surface magnetic flux density of approximately 19 mT when supplied with DC 24V, and an attraction force of 25N when supplied with DC 24V.

With this state, the workpiece holding device X was lifted in its entirety by about 5 cm and maintained for 300 seconds, and a case of the test workpiece having been held by the workpiece holding device X without being dropped during that time was evaluated as ○: pass, and a case of the test workpiece having been dropped was evaluated as ×: fail. Further, for comparative reference, a case in which the workpiece holding device X was lifted in the same manner as described above, without supplying current (DC 24V) to the electromagnets 6 (the electromagnets turned off) was also evaluated as to whether the test workpieces were dropped. The results are shown in Table 1.

Incidentally, although not being subjected to the evaluation in this experimental example, in removing the test workpiece held on the workpiece holding surface P, the lifted workpiece holding device X was lowered to place the test workpieces on the table, and then, the supply of current (DC 24V) to the two electromagnets 6 was stopped, thereby disengaging the integration of the pedestal block 5 and the belt-like sheet 1. This renders the belt-like sheet 1 deformable. Then, the rod of the air cylinder 11 was pushed out with an air supply pressure of approximately 0.3 MPa to move the upper plate 9 upward and accordingly, to lift the base surface 5a of the pedestal block 5, so that with the non-adhesive holding material 3 attached to the center of one surface 1a of the belt-like sheet 1 being kept pressed against the test workpiece, the belt-like sheet 1 is deformed so as to separate the base surface 5a of the pedestal block 5 and the other surface 1b of the belt-like sheet 1. Then, the adhesive holding material 2 is peeled off from the surface of the test workpiece so as to be rolled up from the end of the belt-like sheet 1, and the test workpiece is removed. Note that the above-described air cylinder 11 was a double-acting air cylinder having a cylinder tube diameter of 12 mm and a stroke of 10 mm, and its operation was controlled by an electromagnetic valve.

**[Table 1]**

| State of electromagnet | Test workpiece (weight) | | |
|---|---|---|---|
| | w1 (1.1 kg) | w2 (1.7 kg) | w3 (3.7 kg) |
| OFF | × | × | × |
| ON | ○ | ○ | ○ |

As shown in Table 1, the workpiece holding device X according to the present invention was able to adhesively hold all three types of test workpieces w1 to w3 having different weights. On the other hand, in the case in which the pedestal block 5 and the belt-like sheet 1 were not integrated, without supplying current to the electromagnets 6, the test workpieces w1 to w3 could not be properly held. Among these, the test workpieces w1 and w2 could be temporarily lifted from the table, together with the workpiece holding device X as a whole, but dropped in less than 20 seconds. Further, the test workpiece w3 could not even be lifted from the table by the workpiece holding device X. That is, according to the workpiece holding device X of the present invention, the elastically deformable belt-like sheet was integrated with the pedestal block, and its deformation was restricted, thereby restricting the deformation of the adhesive holding material itself, so that even the heavy workpiece could be surely, adhesively held.

As described above, according to the present invention, a workpiece can be held with a sufficient adhesive force, and separation without applying a load to the held workpiece is possible. Moreover, the workpiece holding device of the present invention adhesively holds a workpiece using the van der Waals force on the surface, and is thus versatile for any type or shape of workpiece, and application in a broad range is available, for example, for use as a workpiece transporting device for transporting various types of workpieces, use as part of a robot hand that picks up workpieces, or use for fixing workpieces.

### Reference Signs List

1: belt-like sheet
2: adhesive holding material
3: non-adhesive holding material
4: locking part
5: pedestal block
5a: base surface
6: electromagnet
7: workpiece pressing portion
8: support
9: upper plate
10: vertical guide
11: air cylinder
11a: rod
12: through-hole

## Claims

1. A workpiece holding device for holding a workpiece using a self-adhesive adhesive holding material, the workpiece holding device comprising:
a belt-like sheet having one surface to which the adhesive holding material is attached, the belt-like sheet being elastically deformable;
a pedestal block having a base surface; and
an integrating means adapted to bring the base surface of the pedestal block and another surface of the belt-like sheet into close contact with each other to be integrated,
wherein
in holding the workpiece, the pedestal block and the belt-like sheet are integrated by the integrating means to form a workpiece holding surface, thereby adhesively holding the workpiece, and
in removing the workpiece, integration of the pedestal block and the belt-like sheet by the integrating means is disengaged to separate the base surface of the pedestal block and the other surface of the belt-like sheet, thereby peeling off the workpiece from the workpiece holding surface.

2. The workpiece holding device according to claim 1, wherein in removing the workpiece, the workpiece is peeled off from the workpiece holding surface while performing restriction by a workpiece restricting means that restricts movement of the workpiece toward the pedestal block.

3. The workpiece holding device according to claim 1, wherein the integrating means is formed by an electromagnet attached to the pedestal block and the belt-like sheet made of a magnetic material, the integrating means being adapted to bring an inner side surface of the belt-like sheet and the base surface of the pedestal block into close contact with each other, with an excitation current supplied to the electromagnet.

4. The workpiece holding device according to claim 1, wherein the integrating means is formed by a suction pump connected to the pedestal block and a suction port that sucks an inner side surface of the belt-like sheet, the integrating means being adapted to bring the inner side surface of the belt-like sheet and the base surface of the pedestal block into close contact with each other, by sucking air with the suction pump.

5. The workpiece holding device according to claim 1, wherein the pedestal block has a locking part, and the belt-like sheet is locked to the locking part of the pedestal block, with a surface having the adhesive holding material facing outward.

6. The workpiece holding device according to claim 1, comprising a through-hole passing through from the pedestal block to the adhesive holding material, with the workpiece holding surface formed by the pedestal block and the belt-like sheet closely contacting with each other,
wherein through observation of a flow rate or a pressure of gas within the through-hole, a state of adhesively holding the workpiece on the workpiece holding surface is able to be detected.
